# EUROPEAN PATENT APPLICATION

(11) **EP 4 669 041 A1**
(43) Date of publication of application: **24.12.2025**
(21) Application number: 25182922.2
(22) Date of filing: 16.06.2025
(51) Int. Cl.: H05K 7/14, H05K 7/20

(54) **SUPERCOMPUTING SERVER AND DATA CENTER**

(30) Priority: 18.06.2024 CN 202421408413 U
(71) Applicant: Bitdeer Semiconductor Technology PTE. LTD., 049514 Singapore (SG)
(72) Inventor: LI, WEIGUO, 049514 Singapore (SG); YANG, SENFENG, 049514 Singapore (SG); DAI, QIANG, 049514 Singapore (SG)
(74) Representative: Metida

(57) **Abstract**

Disclosed are a supercomputing server and a data center. The supercomputing server includes a chassis and a liquid-cooled module. The chassis includes a cover plate, a base plate, and a first side panel, a second side panel, a third side panel and a fourth side panel that are sequentially end-to-end connected. The side panels are connected to the base plate and extend from a same surface thereof to form an accommodating space with the base plate. The base plate, the second side panel, and the fourth side panel each extend beyond the first side panel to form a protective space. A first slot and a second slot are arranged in the first side panel. The cover plate covers the accommodating space. The liquid-cooled computing module has a first end wall, a first medium port, and a second medium port.

## Description

### TECHNICAL FIELD

The present disclosure relates to the technical field of supercomputing servers, and in particular, relates to a supercomputing server and a data center.

### BACKGROUND

Currently, various cooling methods are employed for supercomputing servers, such as air cooling, liquid cooling, and immersion oil cooling. Liquid cooling is a method that utilizes a coolant to remove heat generated by numerous high-performance chips operating inside the supercomputing server, by means of heat exchange.

However, in the related arts that utilize liquid cooling for supercomputing servers, the arrangement of liquid cooling piping is often complex, and its reliability is relatively inadequate. Consequently, these systems suffer from drawbacks such as inconvenient installation and even the potential for liquid leakage inside the chassis.

### SUMMARY

In view of the above, the present disclosure is intended to provide a supercomputing server and a data center. The liquid cooling piping structure of the supercomputing server is simple in construction and easy to install, and offers exceptionally high operational reliability.

To achieve the above objective, the present disclosure employs the following technical solutions:
In a first aspect, embodiments of the present disclosure provide a supercomputing server. The supercomputing server includes a chassis and a liquid-cooled computing module; wherein
the chassis includes a cover plate, a base plate, and a first side panel, a second side panel, a third side panel and a fourth side panel that are sequentially end-to-end connected; wherein the side panels are connected to the base plate and extend from a same surface thereof to form an accommodating space with the base plate; the base plate, the second side panel, and the fourth side panel each extend beyond the first side panel to form a protective space; a first slot and a second slot are arranged in the first side panel; and the cover plate covers the accommodating space;
the liquid-cooled computing module includes a hash board, the hash board including a plurality of columns of chip groups disposed on a same surface of the hash board, wherein the plurality of columns of chip groups are sequentially arranged along a width direction of the hash board, each of the chip groups comprises a plurality of series-connected chips, and circuits between the plurality of columns of chip groups are connected in parallel;
the liquid-cooled computing module has a first end wall, a first medium port, and a second medium port, wherein the first medium port and the second medium port extend from the first end wall; and the liquid-cooled computing module is installed in the accommodating space, the first end wall is abutted against the first side panel, the first medium port and the second medium port respectively extend through the first slot and the second slot, and portions of both the first medium port and the second medium port extending beyond the first side panel are disposed within the protective space.

In some embodiments, a third slot and a fourth slot are further arranged in the first side panel; and the supercomputing server further comprises a liquid-cooled power module and a connecting piping; wherein
the liquid-cooled power module has a second end wall, a third medium port, and a fourth medium port, wherein the third medium port and the fourth medium port extend through the second end wall; and the liquid-cooled power module is installed in the accommodating space, the second end wall faces the first side panel, and the third medium port and the fourth medium port respectively extend through the third slot and the fourth slot; and
two ends of the connecting piping are respectively connected to the second medium port and the third medium port; and portions of the third medium port and the fourth medium port that extend through the first side panel, and the connecting piping are all disposed within the protective space.

In some embodiments, the chassis further includes a liquid barrier strip, the liquid barrier strip including a bottom liquid barrier portion, wherein the bottom liquid barrier portion is disposed along an edge of a portion of the base plate extending beyond the first side panel, and faces the first side panel.

In some embodiments, the liquid barrier strip further includes a side liquid barrier portion, wherein the side liquid barrier portion is disposed along edges of portions of the second side panel and the fourth side panel that extend beyond the first side panel, and faces the first side panel.

In some embodiments, the liquid barrier strip is an integrally formed component.

In some embodiments, liquid drainage slots are arranged in a portion of the base plate extending beyond the first side panel.

In some embodiments, a number of the liquid drainage slots is four, and the four liquid drainage slots are respectively disposed in four corners of the portion of the base plate extending beyond the first side panel.

In some embodiments, the supercomputing server further includes a first connector and a second connector, wherein the first connector is connected to the first medium port, the second connector is connected to the second medium port, and the first connector and the second connector are both disposed within the protective space.

In some embodiments, the supercomputing server further includes a third connector and a fourth connector, wherein the third connector is connected to the third medium port, the fourth connector is connected to the fourth medium port, and the third connector and the fourth connector are both disposed within the protective space.

In a second aspect, embodiments of the present disclosure further provide a data center. The data center includes the supercomputing server as described above.

In the present disclosure, by configuring the chassis of the supercomputing server to form the accommodating space and the protective space, the first end wall of the liquid-cooled computing module within the accommodating space is brought into contact with the first side panel of the chassis. In a case where the first medium port and the second medium port extend through the first end wall, the first medium port and the second medium port respectively extend through the first slot and the second slot in the first side panel to the exterior of the accommodating space, thereby effectively preventing the occurrence of leakage within the accommodating space of the chassis. The portions of the first medium port and the second medium port that extend through the first side panel are disposed within the protective space, and are less susceptible to external damages, such that operational reliability is further enhanced. Furthermore, the supercomputing server has a simple overall structure and is easy to assemble, which significantly improves the assembly efficiency.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of the present disclosure are described with reference to accompanying drawings hereinafter.
FIG. 1 is a schematic perspective structural view of a supercomputing server according to some embodiments of the present disclosure;
FIG. 2 is a schematic perspective structural view of a supercomputing server according to some embodiments of the present disclosure;
FIG. 3 is a schematic perspective structural view of a supercomputing server in FIG. 2 with a cover plate removed;
FIG. 4 is a schematic perspective structural view of chassis with a cover plate removed according to some embodiments of the present disclosure;
FIG. 5 is a schematic perspective structural view of a liquid barrier strip according to some embodiments of the present disclosure; and
FIG. 6 is a schematic perspective structural view of a supercomputing server according to some embodiments of the present disclosure.

Reference numerals and denotations thereof: 100. Chassis; 110. First side panel; 111. First slot; 112. Second slot; 113. Third slot; 114. Fourth slot; 120. Second side panel; 130. Third side panel; 140. Fourth side panel; 150. Cover plate; 160. Base plate; 161. Liquid drainage slot; 170. Accommodating space; 180. Protective space; 200. Liquid-cooled computing module; 210. First end wall; 220. First medium port; 230. Second medium port; 300. Liquid-cooled power module; 310. Second end wall; 320. Third medium port; 330. Fourth medium port; 400. Connecting piping; 500. Liquid barrier strip; 510. Bottom liquid barrier portion; 520. Side liquid barrier portion; 610. First connector; 620. Fourth connector.

### DETAILED DESCRIPTION

The present disclosure is described with reference to some exemplary embodiments. However, the present disclosure is not limited to these exemplary embodiments.

In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance.

In addition, in the description of the present disclosure, the term "multiple," "more," or "a plurality of" refers to at least two unless otherwise specified.

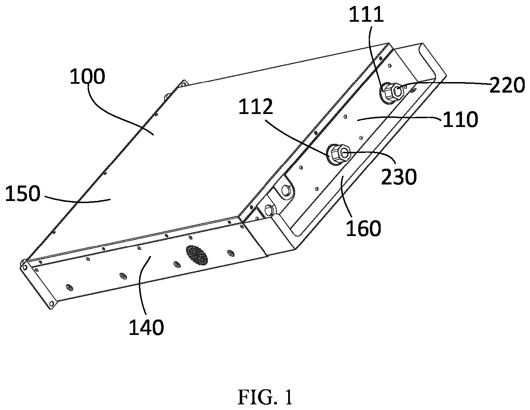

Referring to FIG. 1 to FIG. 4, and FIG. 6, some embodiments of the present disclosure provide a supercomputing server. The supercomputing server includes a chassis 100 and a liquid-cooled computing module 200. The chassis 100 includes a cover plate 150, a base plate 160, and a first side panel 110, a second side panel 120, a third side panel 130 and a fourth side panel 140 that are sequentially end-to-end connected. The side panels are connected to the base plate 160 and extend from a same surface thereof to form an accommodating space 170 with the base plate 160. The base plate 160, the second side panel 120, and the fourth side panel 140 each extend beyond the first side panel 110 to form a protective space 180. A first slot 111 and a second slot 112 are arranged in the first side panel 110. The cover plate 150 covers the accommodating space 170.

The liquid-cooled computing module 200 includes a hash board. The hash board includes a plurality of columns of chip groups disposed on a same surface of the hash board. The plurality of columns of chip groups are sequentially arranged along a width direction of the hash board, each of the chip groups includes a plurality of series-connected chips, and circuits between the plurality of columns of chip groups are connected in parallel.

The liquid-cooled computing module 200 has a first end wall 210, a first medium port 220, and a second medium port 230. The first medium port 220 and the second medium port 230 extend through the first end wall 210. The liquid-cooled computing module 220 is installed in the accommodating space 170, the first end wall 210 is abutted against the first side panel 110, the first medium port 220 and the second medium port 230 respectively extend through the first slot 111 and the second slot 112, and portions of both the first medium port 220 and the second medium port 230 that extend through the first side panel 110 are disposed within the protective space 180.

Specifically, in the supercomputing server according to the present disclosure, a liquid cooling method using a coolant is employed to dissipate heat from the computing module. Corresponding coolant flow channels are integrated into the computing module, and thus the liquid-cooled computing module 200 is practiced. The first medium port 220 and the second medium port 230 are a coolant inlet and a coolant outlet (the present disclosure does not clearly define which of the first medium port 220 and the second medium port 230 is the coolant inlet and which is the coolant outlet; and the coolant inlet and the coolant outlet may be respectively assigned the functions of coolant inflow and coolant outflow according to actual needs).

The liquid-cooled computing module 200 is one of the core components of the supercomputing server and is thus installed in the accommodating space 170 formed by the chassis 100.

The accommodating space 170 is formed such that the chassis 100 includes the cover plate 150, the base plate 160, and the first side panel 110, the second side panel 120, the third side panel 130 and the fourth side panel 140 that are sequentially end-to-end connected; and that the side panels are connected to the same side of the base plate 160 and form the accommodating space 170 together with the base plate 160. Furthermore, the accommodating space 170 is covered by the cover plate 150, such that the accommodating space 170 is at least substantially enclosed, so as to protect components installed therein as much as possible from external impacts, interference, and other damages.

Within the accommodating space 170, the first end wall 210 of the liquid-cooled computing module 200 is abutted against the first side panel 110 of the chassis 100. The term "closely abutted" herein refers to the first end wall 210 being in tight contact with the first side panel 110, or, where a gap is present between the first end wall 210 and the first side panel 110, such a gap is unavoidable (for example, due to limitations of installation conditions, a gap may still be present even when using common and mature installation methods).

This "abutted" arrangement is to ensure that in a case where the first medium port 220 and the second medium port 230 of the liquid-cooled computing module 200 extend through the first end wall 210, these medium ports may respectively extend through the first slot 111 and the second slot 112 in the first side panel 110 of the chassis 100 to the exterior of the accommodating space 170. This obviates the need to arrange additional adapter connectors within the accommodating space 170, where one end of such connectors is connected to the first medium port 220/ the second medium port 230 and the other end extends through the corresponding slot in the first side panel 110, thereby effectively preventing the occurrence of leakage caused by adapter connectors within the accommodating space 170.

The specific shapes of the first slot 111 and the second slot 112 are not limited. The slots may be completely enclosed peripherally or not completely enclosed circumferentially, as long as they primarily serve the function of allowing the corresponding medium ports to extend therethrough.

The portions of the first medium port 220 and the second medium port 230 that extend through the first side panel 110 are then disposed within the protective space 180 formed by the chassis 100. The protective space 180 is enclosed by portions of the base plate 160, the second side panel 120, and the fourth side panel 140 that each extend beyond the first side panel 110 (it is evidently not a form enclosed on all six sides). Therefore, the portions of the first medium port 220 and the second medium port 230 that extend beyond the first side panel 110 may receive corresponding protection, and further this does not hinder the first medium port 220 and the second medium port 230 from being smoothly connected to an external coolant supply apparatus to receive supply of the coolant.

In the present disclosure, by configuring the chassis 100 of the supercomputing server to form the accommodating space 170 and the protective space 180, the first end wall 210 of the liquid-cooled computing module 200 within the accommodating space 170 is brought into contact with the first side panel 110 of the chassis 100. In a case where the first medium port 220 and the second medium port 230 extend through the first end wall 210, the first medium port 220 and the second medium port 230 respectively extend through the first slot 111 and the second slot 112 in the first side panel 110 to the exterior of the accommodating space 170, thereby effectively preventing the occurrence of leakage within the accommodating space 170 of the chassis 100. The portions of the first medium port 220 and the second medium port 230 that extend through the first side panel are disposed within the protective space 180, and are less susceptible to external damages, such that operational reliability is further enhanced. Furthermore, the supercomputing server has a simple overall structure and is easy to assemble, which significantly improves the assembly efficiency.

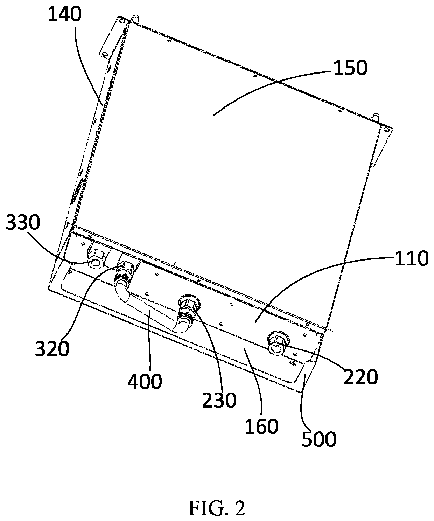

In some embodiments, particularly referring to FIG. 2 to FIG. 4, a third slot 1113 and a fourth slot 114 are further arranged in the first side panel 110; and the supercomputing server further includes a liquid-cooled power module 300 and a connecting piping 400.

The liquid-cooled power module 300 has a second end wall 310, a third medium port 320, and a fourth medium port 330. The third medium port 320 and the fourth medium port 330 extend through the second end wall 310. The liquid-cooled power module 300 is installed in the accommodating space 170, the second end wall 310 faces the first side panel 110, and the third medium port 320 and the fourth medium port 330 respectively extend through the third slot 113 and the fourth slot 114.

Two ends of the connecting piping 400 are respectively connected to the second medium port 230 and the third medium port 320. Portions of the third medium port 320 and the fourth medium port 330 that extend through the first side panel 110, and the connecting piping 400 are all disposed within the protective space 180.

Specifically, in the supercomputing server according to the present disclosure, a liquid cooling method using a coolant is employed to dissipate heat from the computing module. Corresponding coolant flow channels are integrated into the computing module, and thus the liquid-cooled power module 300 is practiced. The third medium port 320 and the fourth medium port 330 are a coolant inlet and a coolant outlet (the present disclosure does not clearly define which of the third medium port 320 and the fourth medium port 330 is the coolant inlet and which is the coolant outlet, which may be defined according to actual needs).

The liquid-cooled power module 300 is also installed within the accommodating space 170 formed by the chassis 100.

In a case where the third medium port 320 and the fourth medium port 330 of the liquid-cooled computing module 300 extend through the second end wall 310, these medium ports may respectively extend through the third slot 113 and the fourth slot 114 in the first side panel 110 of the chassis 100. Likewise, this also obviates the need to arrange additional adapter connectors within the accommodating space 170, where one end of such connectors is connect to the third medium port 320/the fourth medium port 330 and the other end extends through the corresponding slot in the first side panel 110, thereby effectively preventing the occurrence of leakage caused by adapter connectors within the accommodating space 170.

The specific shapes of the third slot 113 and the fourth slot 114 are not limited. The slots may be completely enclosed peripherally or not completely enclosed circumferentially, as long as they primarily serve the function of allowing the corresponding medium ports to extend therethrough.

Furthermore, the portions of the third medium port 320 and the fourth medium port 330 that extend through the first side panel 110 are also disposed within the protective space 180 formed by the chassis 100, and these two ports also receive the corresponding protection.

The connecting piping 400 may then be connected to the second medium port 230 and the third medium port 320, such that the coolant used by the liquid-cooled computing module 200 and the liquid-cooled power module 300 may be in fluid communication with each other. In a specific example, the coolant may first pass through the liquid-cooled computing module 200, flow out from the second medium port 230, and then flow through the connecting piping 400 into the third medium port 320, thereby entering the liquid-cooled power module 300. The flow direction of the coolant may also be exactly opposite to that in the aforementioned example, which may be flexibly set and selected according to actual needs.

In some embodiments, particularly referring to FIG. 2, FIG. 4, and FIG. 5, the chassis 100 further includes a liquid barrier strip 500. The liquid barrier strip 500 includes a bottom liquid barrier portion 510. The bottom liquid barrier portion 510 is disposed along an edge of a portion of the base plate 160 extending beyond the first side panel 110, and faces the first side panel 110.

Specifically, the liquid barrier strip 500 is configured to ensure that in a case where leakage occurs at the connection points when the medium ports are connected to an external coolant supply apparatus outside the first side panel 110, the leakage is blocked or stopped by the liquid barrier strip 500, thereby minimizing its outflow beyond the chassis 100 and preventing contamination of the environment external to the chassis 100.

The bottom liquid barrier portion 510 of the liquid barrier strip 500 may be disposed along the edge of the portion of the base plate 160 that extends beyond the first side panel 110, and faces the first side panel 110. This allows leakage to be trapped between the liquid barrier strip 500 and the first side panel 110, where the leakage is supported by the base plate 160.

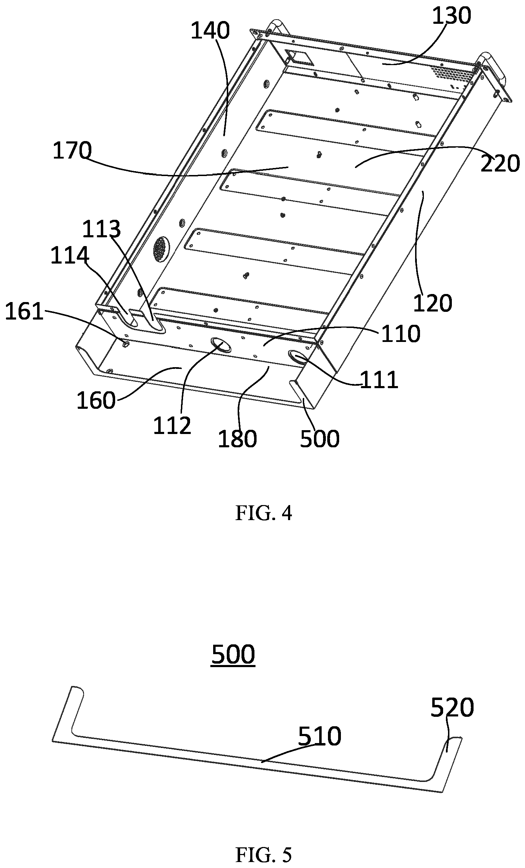

In some embodiments, particularly referring to FIG. 5, the liquid barrier strip 500 further includes a side liquid barrier portion 520. The side liquid barrier portion 520 is disposed along edges of portions of the second side panel 120 and the fourth side panel 140 that extend beyond the first side panel 110, and faces the first side panel 110.

To further enhance the liquid barrier effect, the liquid barrier strip 500 may also include a side liquid barrier portion 520. The side liquid barrier portion 520 may include two parts. One part is disposed along the edge of the portion of the second side panel 120 that extends beyond the first side panel 110. The other part is disposed along the edge of the portion of the fourth side panel 140 that extends beyond the first side panel 110.

In this manner, the side liquid barrier portion 520 and the bottom liquid barrier portion 510 are end-to-end connected, forming a U-shape or a shape similar to a U; and the liquid barrier effect is thereby further enhanced.

In some embodiments, the liquid barrier strip 500 is an integrally formed component.

With the above configuration, the liquid barrier strip 500 may be manufactured in a single process, which is conducive to improving the manufacturing and assembly efficiency.

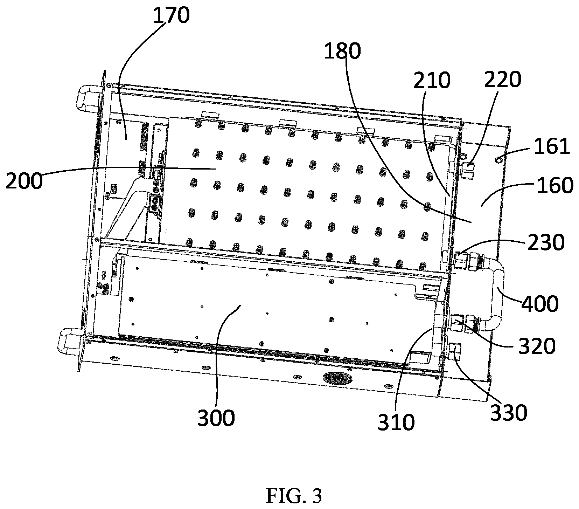

In some embodiments, particularly referring to FIG. 3 and FIG. 4, liquid drainage slots 161 are arranged in a portion of the base plate 160 extending beyond the first side panel 110.

In some embodiments, a number of the liquid drainage slots 161 is four, and the four liquid drainage slots 161 are respectively disposed in four corners of the portion of the base plate 160 extending beyond the first side panel 110.

By arrangement of the liquid drainage slots 161, any leaked liquid collected within the liquid barrier strip 500 may be promptly discharged. Correspondingly, a liquid collection container may be placed at an external location corresponding to the area beneath the liquid drainage slots 161 to collect the leaked liquid, such that the leaked liquid is prevented from flowing freely and causing unnecessary contamination.

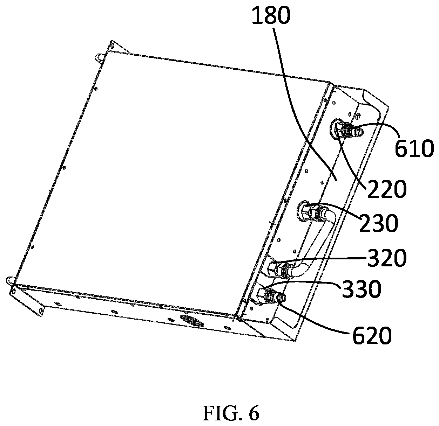

In some embodiments, particularly referring to FIG. 6, the supercomputing server further includes a first connector 610 and a second connector. The first connector 610 is connected to the first medium port 220, the second connector is connected to the second medium port 230, and the first connector 610 and the second connector are both disposed within the protective space 180.

In some embodiments, particularly referring to FIG. 6, the supercomputing server further includes a third connector and a fourth connector 620. The third connector is connected to the third medium port 320, the fourth connector 620 is connected to the fourth medium port 330, and the third connector and the fourth connector 620 are disposed within the protective space 180.

By arrangement of the first connector 610, the second connector, the third connector, and the fourth connector 620, adapter components are provided for connecting the first medium port 220, the second medium port 230, the third medium port 320, and the fourth medium port 330 within the protective space 180 to an external coolant supply apparatus. This allows a coolant to smoothly flow into/out of the supercomputing server through the corresponding connectors, thereby achieving a good heat dissipation effect for the supercomputing server.

Furthermore, the first connector 610 and the fourth connector 620 also support quick connection with external equipment. In this way, while achieving a bidirectional water-stop function, the connectors also facilitate the convenient and rapid detachment of an external device from the corresponding connectors for repair, maintenance, or replacement purposes.

Some embodiments of the present disclosure further provide a data center. The data center includes the supercomputing server as described above.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A supercomputing server, comprising: a chassis (100) and a liquid-cooled computing module (200); wherein
the chassis (100) comprises a cover plate (150), a base plate (160), and a first side panel (110), a second side panel (120), a third side panel (130) and a fourth side panel (140) that are sequentially end-to-end connected; wherein the side panels are connected to the base plate (160) and extend from a same surface thereof to form an accommodating space (170) with the base plate (160); the base plate (160), the second side panel (120), and the fourth side panel (140) each extend beyond the first side panel (110) to form a protective space (180); a first slot (111) and a second slot (112) are arranged in the first side panel (110); and the cover plate (150) covers the accommodating space (170);
the liquid-cooled computing module (200) comprises a hash board, the hash board comprising a plurality of columns of chip groups disposed on a same surface of the hash board, wherein the plurality of columns of chip groups are sequentially arranged along a width direction of the hash board, each of the chip groups comprises a plurality of series-connected chips, and circuits between the plurality of columns of chip groups are connected in parallel;
the liquid-cooled computing module (200) has a first end wall (210), a first medium port (220), and a second medium port (230), wherein the first medium port (220) and the second medium port (230) extend from the first end wall (210); and
the liquid-cooled computing module (200) is installed in the accommodating space (170), the first end wall (210) is abutted against the first side panel (110), the first medium port (220) and the second medium port (230) respectively extend through the first slot (111) and the second slot (112), and portions of both the first medium port (220) and the second medium port (230) that extend beyond the first side panel (110) are disposed within the protective space (180).

2. The supercomputing server according to claim 1, wherein a third slot (113) and a fourth slot (114) are further arranged in the first side panel (110); and the supercomputing server further comprises a liquid-cooled power module (300) and a connecting piping (400); wherein
the liquid-cooled power module (300) has a second end wall (310), a third medium port (320), and a fourth medium port (330), wherein the third medium port (320) and the fourth medium port (330) extend beyond the second end wall (310); and the liquid-cooled power module (300) is installed in the accommodating space (170), the second end wall (310) faces the first side panel (110), and the third medium port (320) and the fourth medium port (330) respectively extend through the third slot (113) and the fourth slot (114); and
two ends of the connecting piping (400) are respectively connected to the second medium port (230) and the third medium port (320); and portions of the third medium port (320) and the fourth medium port (330) that extend beyond the first side panel (110), and the connecting piping (400) are all disposed within the protective space (180).

3. The supercomputing server according to claim 1, wherein the chassis (100) further comprises a liquid barrier strip (500), the liquid barrier strip comprising a bottom liquid barrier portion (510), wherein the bottom liquid barrier portion (510) is disposed along an edge of a portion of the base plate (160) extending beyond the first side panel (110), and faces the first side panel (110).

4. The supercomputing server according to claim 3, wherein the liquid barrier strip (500) further comprises a side liquid barrier portion (520), wherein the side liquid barrier portion (520) is disposed along edges of portions of the second side panel (120) and the fourth side panel (140) that extend beyond the first side panel (110), and faces the first side panel (110).

5. The supercomputing server according to claim 4, wherein the liquid barrier strip (500) is an integrally formed component.

6. The supercomputing server according to claim 1, wherein liquid drainage slots (161) are arranged in a portion of the base plate (160) extending beyond the first side panel (110).

7. The supercomputing server according to claim 6, wherein a number of the liquid drainage slots (161) is four, and the four liquid drainage slots (161) are respectively disposed in four corners of the portion of the base plate (160) extending beyond the first side panel (110).

8. The supercomputing server according to claim 1, further comprising: a first connector (610) and a second connector, wherein the first connector (610) is connected to the first medium port (220), the second connector is connected to the second medium port (230), and the first connector (610) and the second connector both are disposed within the protective space (180).

9. The supercomputing server according to claim 2, further comprising: a third connector and a fourth connector (620), wherein the third connector is connected to the third medium port (320), the fourth connector (620) is connected to the fourth medium port (330), and the third connector and the fourth connector (620) are both disposed within the protective space (180).

10. A data center, comprising: a plurality of supercomputing servers according to any one of claims 1 to 9.
